# EUROPÄISCHE PATENTSCHRIFT

(11) **EP 1 148 352 B1**
(45) Veröffentlichungstag und Bekanntmachung des Hinweises auf die Patenterteilung: **06.10.2010**
(21) Anmeldenummer: 01107898.7
(22) Anmeldetag: 11.04.2001
(51) Int. Cl.: G01V 8/20

(54) **Optischer Sensor**
Optical sensor
Capteur optique

(30) Priorität: 22.04.2000 DE 10020112
(43) Veröffentlichungstag der Anmeldung: 24.10.2001
(73) Patentinhaber: Leuze electronic GmbH + Co. KG, 73277 Owen/Teck (DE)
(72) Erfinder: Quapil Gerald, Dr., 73277 Owen/Teck (DE); Schönhaar, Jürgen, 72669 Unterensingen (DE); Allgaier, Roland, 73268 Erkenbrechtsweiler (DE)
(74) Vertreter: Ruckh, Rainer Gerhard

(56) Entgegenhaltungen:
- WO-A-90/02937
- DE-A- 4 422 497
- DE-A- 19 544 632
- FR-A- 2 545 925
- US-A- 4 559 452
- US-A- 5 753 905

## Beschreibung

Die Erfindung betrifft einen optischen Sensor gemäß dem Oberbegriff des Anspruchs 1.

Derartige Sensoren können insbesondere als Lichtschranken ausgebildet sein. Der Sender und der Empfänger der Lichtschranke sind in getrennten Gehäusen in Abstand zueinander angeordnet, so dass bei freiem Strahlengang die vom Sender emittierten Sendelichtstrahlen auf den Empfänger treffen. Tritt ein Objekt in den Strahlengang der Lichtschranke, so treffen die Sendelichtstrahlen nicht mehr oder nur noch teilweise auf den Empfänger. Aus den Amplituden der am Ausgang des Empfängers anstehenden Empfangssignale wird ein binäres Schaltsignal abgeleitet, welches angibt, ob sich ein Objekt im Strahlengang der Lichtschranke befindet oder nicht.

Weiterhin können derartige Sensoren auch als Gabellichtschranken ausgebildet sein, wobei in diesem Fall der Sensor in einem gabelförmigen Gehäuse integriert ist. Das Gehäuse weist zwei gabelförmige Gehäuseelemente auf, die beidseits des zu überwachenden Bereichs in Abstand zueinander liegen. Dabei werden bei freiem Strahlengang die Sendelichtstrahlen, die von dem in einem ersten Gehäuseelement integrierten Sender emittiert werden, auf den Empfänger geführt, der im zweiten Gehäuseelement angeordnet ist.

Durch Verwendung geeigneter Sende- und Empfangsoptiken, welche dem Sender beziehungsweise dem Empfänger zugeordnet sind, wird ein kollimierter Strahlverlauf der Sendelichtstrahlen im zu überwachenden Bereich erhalten, wobei die Sendelichtstrahlen mittels der Empfangsoptik auf den Empfänger abgebildet werden. Bei Eintritt eines Objektes in den Strahlengang der Sendelichtstrahlen werden zumindest Teile des Empfängers abgeschattet. Dies führt zu einer entsprechenden Objektmeldung im optischen Sensor. Der Empfänger des Sensors kann dabei von einem ortsauflösenden Sensor gebildet sein, so dass eine entsprechend ortsaufgelöste Erfassung der Abschattung durch die Objekte möglich ist.

Nachteilig hierbei ist jedoch, dass kleine Objekte sowie insbesondere deren Konturen und Kanten nur ungenau erfassbar sind. Dies beruht darauf, dass die Objekte nur kleine Ausschnitte der kollimierten Sendelichtstrahlen abschatten, so dass die durch den Objekteingriff bewirkte Signaländerung entsprechend gering ist.

Die DE 195 44 632 A1 betrifft eine optoelektronische Vorrichtung zum Erfassen von Objekten in einem Überwachungsbereich mit einem Empfänger und wenigstens einem Sender, welche gegenüberliegend an den Rändern des Überwachungsbereichs so angeordnet sind, dass ein im Überwachungsbereich angeordnetes Objekt den Strahlengang der vom Sender zum Empfänger geführten Sendelichtstrahlbündel zumindest teilweise unterbricht, worauf in einer an den Empfänger angeschlossenen Auswerteeinheit eine Objektmeldung ausgelöst wird. Der Empfänger besteht aus einer linearen Anordnung von photosensitiven Elementen. Während einer Abgleichphase werden die bei freiem Strahlengang belichteten und nicht belichteten photosensitiven Elemente in der Auswerteeinheit registriert und diese Signalwerte als Referenzwerte abgespeichert. Während einer auf die Abgleichphase folgenden Arbeitsphase werden die Signalwerte der photosensitiven Elemente fortlaufend registriert und als Istwerte mit den Referenzwerten verglichen. Durch den Vergleich der Istwerte mit den Referenzwerten erfolgt die Erfassung der Objekte im Überwachungsbereich.

Die US-A-5,753,905 betrifft einen optischen Sensor zur Inspektion von geometrischen Parametern von Behältern. Der Sensor weist eine Lichtquelle mit zwei nachgeordneten Linsen auf, mit denen eine flächige kollimierte Beleuchtung eines Überwachungsbereichs erhalten wird, in dem die zu detektierenden Behälter angeordnet sind. Mit einer nachgeordneten Empfangsoptik wird dann das den Überwachungsbereich verlassende Licht der Lichtquelle auf einen CCD-Empfänger abgebildet.

Die FR-A 25 45 925 betrifft eine Gabellichtschranke mit einem Licht emittierenden Sender und einer linienförmigen Anordnung von Empfängern.

Die WO-A-900 29 37 betrifft eine Sensoranordnung zur Inspektion von Flaschenhülsen. Von einer Lichtquelle emittiertes Licht wird über eine Diffuserplatte aufgestreut und leuchtet so einen Erfassungsbereich aus, in welchem der zu detektierende Flaschenhals angeordnet ist. Schräg oberhalb des Überwachungsbereichs befindet sich eine Kamera, mittels derer Bilder vom Flaschenhals aufgenommen werden.

Der Erfindung liegt die Aufgabe zugrunde einen Sensor der eingangs genannten Art so auszubilden, dass Objekte mit einer möglichst großen Nachweisempfindlichkeit erfassbar sind.

Zur Lösung dieser Aufgabe sind die Merkmale des Anspruchs 1 vorgesehen. Vorteilhafte Ausführungsformen und zweckmäßige Weiterbildungen der Erfindung sind in den Unteransprüchen beschrieben.

Der erfindungsgemäße optische Sensor weist wenigstens einen Sender und wenigstens einen in Abstand zu diesem angeordneten Empfänger auf. Die vom Sender emittierten Sendelichtstrahlen sind bei freiem Strahlengang auf den Empfänger geführt. Bei einem Objekteingriff sind die Sendelichtstrahlen zumindest teilweise abgeschwächt. Der Empfänger ist von einem eine vorgegebene Anzahl von Empfangselementen aufweisenden Zeilenelement gebildet. Die Sendelichtstrahlen sind auf die Empfangselemente fokussiert und leuchten diese bei freiem Strahlengang vollständig aus. Weiterhin sind Mittel zur Erfassung von Konturen und/oder Kanten von im Strahlengang der Sendelichtstrahlen angeordneten Objekten vorgesehen.

Ein wesentlicher Vorteil des erfindungsgemäßen Sensors besteht darin, dass durch die Verwendung eines Zeilenelements als Empfänger bei der Objektdetektion eine hohe Ortsauflösung in Längsrichtung des Zeilenelements erhalten wird, wobei die Ortsauflösung im Wesentlichen durch die Zahl der Empfangselemente vorgegeben ist.

Besonders vorteilhaft werden als Empfänger CCD-Zeilenelemente oder CMOS-Zeilenelemente eingesetzt. Diese Zeilenelemente weisen eine große Anzahl identischer Empfangselemente auf. Die fotoempfindlichen Flächen der Empfangselemente weisen typischerweise eine quadratische Form mit Kantenlängen im Bereich einiger µm auf.

Erfindungsgemäß werden die vom Sender emittierten Sendelichtstrahlen auf den Empfänger fokussiert, so dass diese die Empfangselemente bei freiem Strahlengang vollständig ausleuchten.

Die Strahlbreite der Sendelichtstrahlen quer zur Längsachse des Zeilenelements nimmt somit vom Sender zum Empfänger hin kontinuierlich ab, wobei die Strahlbreite der Sendelichtstrahlen an der Oberfläche des Empfängers im Wesentlichen der Breite des Zeilenelements entspricht.

Diese Strahlführung führt zu einer besonders großen Nachweisempfindlichkeit des Sensors. Dies beruht zum einen darauf, dass die Sendelichtstrahlen vollständig auf den Empfänger abgebildet werden. Zudem kann zur Bestimmung von Konturen und Kanten von Objekten das jeweilige Objekt in einer Distanz zum Empfänger platziert werden, in welcher gerade der gesamte Objektdurchmesser oder die gesamte Struktur eines Objektes, welches mit dem Sensor zu erfassen ist, von den Sendelichtstrahlen ausgeleuchtet wird.

Durch die so gewählte Anordnung der Objekte im Strahlengang der Sendelichtstrahlen wird eine optimierte Abschattung der Sendelichtstrahlen bei einem Objekteingriff und damit eine maximierte Signaländerung der Empfangssignale am Ausgang des Empfängers erhalten.

Die so erhaltene maximierte Signaländerung der Empfangssignale bei einem Objekteingriff führt zu einer entsprechend hohen Nachweisempfindlichkeit des Sensors.

Weiterhin ist vorteilhaft, dass durch die vollständige Ausleuchtung eines Objekts oder einer Objektstruktur mit den Sendelichtstrahlen die dabei erhaltenen Empfangssignale weitgehend unabhängig von Inhomogenitäten der Objektstrukturen, insbesondere Kantenstrukturen der Objekte sind. Der Grund hierfür liegt darin, dass durch die vollständige Ausleuchtung der Gesamtstruktur des Objekts eine optische Integration und Mittelung über die Inhomogenitäten der Objektstrukturen erfolgt.

Der erfindungsgemäße optische Sensor ist besonders vorteilhaft zur Erfassung von Konturen bahnförmiger Objekte, insbesondere netzartiger Textilbahnen geeignet. Insbesondere bei netzartigen Textilbahnen verläuft die Kante des Objektes nicht längs einer Geraden. Vielmehr weist die Kante eine unterbrochene Struktur auf, deren Geometrie möglichst genau zu bestimmen ist, um beispielsweise Positionierungen der Textilbahn durchzuführen.

Weiterhin ist der erfindungsgemäße Sensor bei der Erfassung von flächigen Objekten wie zum Beispiel Blechen einsetzbar. Dabei besteht eine wesentliche Aufgabe darin, mit möglichst hoher Sicherheit separate Bleche von doppellagigen Blechen zu unterscheiden.

Da die Bleche lichtundurchlässig sind, können diese weder im Auflichtverfahren noch im Durchlichtverfahren vermessen werden.

Erfindungsgemäß wird die Unterscheidung von Doppel- und Einfachblechen in Form einer Konturbestimmung unter Verwendung des erfindungsgemäßen Sensors durchgeführt.

Hierzu werden Einfach- oder Doppelbleche derart in den Strahlengang der Sendelichtstrahlen geführt, dass die Sendelichtstrahlen auf deren schmalseitige Seitenflächen treffen. Dabei liegt das jeweils oberste oder unterste Blech in einer definierten Sollposition. Je nach dem ob ein Einfach- oder Doppelblech im Strahlengang der Sendelichtstrahlen liegt, ergibt sich am Empfänger eine unterschiedliche Abschattung der Empfangselemente des Empfängers, anhand derer die Unterscheidung von Einfach- und Doppelblechen erfolgen kann.

Weiterhin kann der erfindungsgemäße Sensor zur Bohrerbruchkontrolle an Werkzeugmaschinen eingesetzt werden. Bei derartigen Anwendungen besteht ein wesentliches Problem darin, dass der Bohrer lückenlos über seine gesamte Länge von dem Sensor erfasst werden muss. Dabei steht für den Sensor jedoch nur ein eng begrenzter Einbauraum an der Werkzeugmaschine zur Verfügung.

Zur Lösung dieses Problems ist die Ausführungsform des Sensors gemäß den Ansprüchen 16 bis 22 vorgesehen, welche eine Mehrfachanordnung von Sendern und Empfängern aufweist.

Die Erfindung wird im nachstehenden anhand der Zeichnungen erläutert. Es zeigen:
- Figur 1:: Längsschnitt durch ein erstes Ausführungsbeispiel des erfindungs- gemäßen optischen Sensors.
- Figur 2:: Querschnitt durch einen Ausschnitt des Sensors gemäß Figur 1.
- Figur 3:: Schematische Darstellung eines Sensors gemäß Figuren 1 und 2 zur Erfassung einer Textilbahn
a) Draufsicht auf ein Gehäuseelement des Sensors.
b) Querschnitt durch einen Ausschnitt des Sensors.
- Figur 4:: Schematische Darstellung eines Sensors gemäß Figuren 1 und 2 zur Erfassung von Blechen
a) Erfassung eines Einfachblechs.
b) Erfassung eines Doppelblechs.
- Figur 5:: Zweites Ausführungsbeispiel des erfindungsgemäßen Sensors
a) Längsschnitt durch den Sensor und einen im Strahlengang ange- ordneten Bohrer.
b) Querschnitt durch ein Gehäuseelement des Sensors.

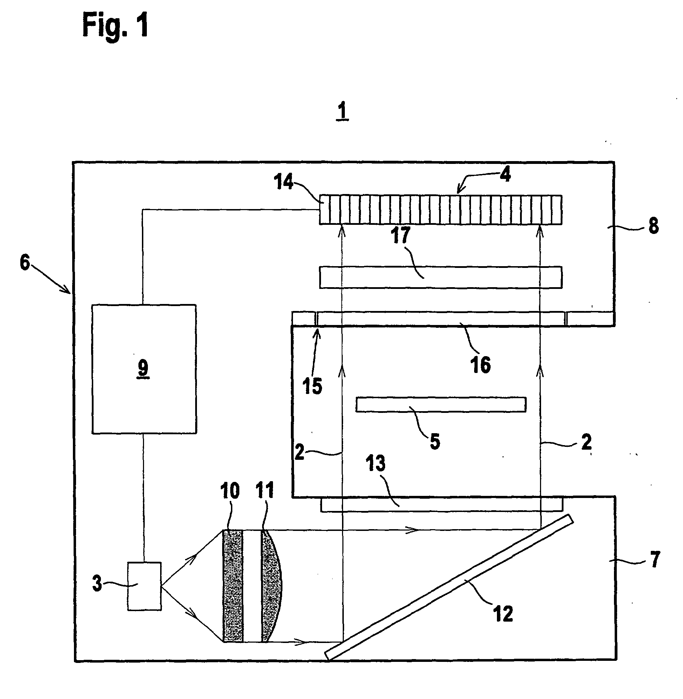

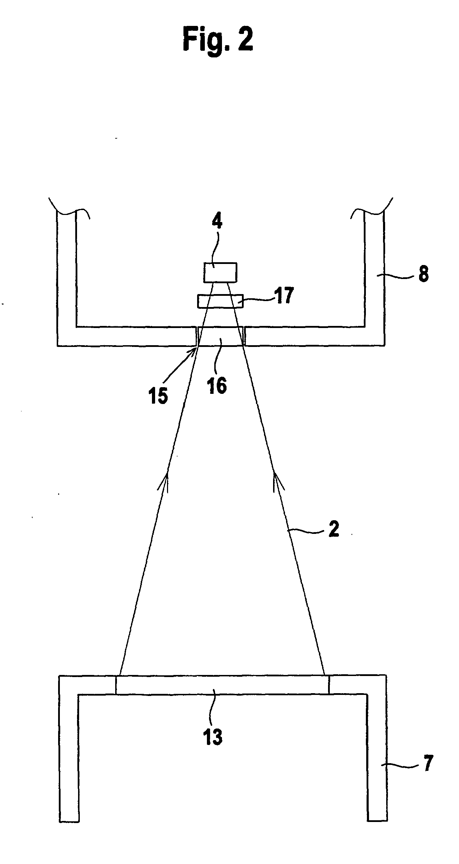

Die Figuren 1 und 2 zeigen ein erstes Ausführungsbeispiel des erfindungsgemäßen optischen Sensors 1. Der Sensor 1 weist einen Sendelichtstrahlen 2 emittierenden Sender 3 sowie einen in Abstand zum Sender 3 angeordneten Empfänger 4 auf.

Zwischen dem Sender 3 und dem Empfänger 4 liegt ein Überwachungsbereich, innerhalb dessen Objekte 5 mit dem Sensor 1 erfasst werden. Die Sendelichtstrahlen 2 sind entlang des Überwachungsbereichs geführt und treffen bei freiem Strahlengang ungehindert auf den Empfänger 4. Bei Eintritt eines Objektes 5 in den Überwachungsbereich trifft zumindest ein Teil der Sendelichtstrahlen 2 auf das Objekt 5. Je nach dem ob ein Objekt 5 transparent oder lichtundurchlässig ist, werden die Sendelichtstrahlen 2 bei Durchgang des Objekts 5 geschwächt oder an diesem reflektiert, so dass höchstens ein Teil der Lichtmenge dieser Sendelichtstrahlen 2 auf das Objekt 5 trifft.

Der Sensor 1 ist im vorliegenden Ausführungsbeispiel von einer Gabellichtschranke gebildet. Dementsprechend weist der Sensor 1 ein gabelförmiges Gehäuse 6 auf. Das Gehäuse 6 weist einen Grundkörper und zwei von diesem hervorstehende parallel zueinander verlaufende Gehäuseelemente 7, 8 auf.

Das erste Gehäuseelement 7 dient zur Aufnahme des Senders 3 und der diesem nachgeordneten optischen Einheiten. Das zweite Gehäuseelement 8 dient zur Aufnahme des Empfängers 4 und der diesem vorgeordneten optischen Einheiten.

In dem Grundkörper befinden sich die elektronischen Komponenten der Gabellichtschranke. Hierzu gehört insbesondere eine Auswerteeinheit 9, die von einem Mikrocontroller oder dergleichen gebildet ist. Die Auswerteeinheit 9 dient zur Auswertung der am Ausgang des Empfängers 4 anstehenden Empfangssignale. Zudem bildet die Auswerteeinheit 9 eine Steuereinheit zur Ansteuerung des Senders 3.

Der Sender 3 ist von einer Leuchtdiode oder einer Laserdiode gebildet. Die vom Sender 3 emittierten Sendelichtstrahlen 2 werden zunächst über eine Sendeoptik geführt. Die Sendeoptik besteht aus einer asphärischen Linse 10 und einer dieser nachgeordneten Zylinderlinse 11. Mittels der asphärischen Linse 10 wird ein kollimiertes Bündel von Sendelichtstrahlen 2 erzeugt. Mittels der Zylinderlinse 11 werden die Sendelichtstrahlen 2 auf den Empfänger 4 fokussiert.

Der Sendeoptik ist ein Umlenkspiegel 12 nachgeordnet. Die Sendelichtstrahlen 2 werden an dem Umlenkspiegel 12 abgelenkt und über ein Austrittsfenster 13 in der Gehäusewand des ersten Gehäuseelements 7 in den Überwachungsbereich geführt.

Der Empfänger 4 ist in Form eines Zeilenelements ausgebildet, welches aus einer linearen Anordnung von Empfangselementen 14 besteht. Das Zeilenelement ist von einem CCD-Zeilenelement oder einem CMOS-Zeilenelement gebildet. Die Empfangselemente 14 sind identisch ausgebildet und weisen insbesondere quadratische Querschnitte mit Kantenlängen im Bereich einiger µm auf. Prinzipiell kann der Empfänger 4 auch aus einem PIN-Dioden-Zeilenelement bestehen.

Durch die Verwendung von CCD-Zeilenelementen beziehungsweise CMOS-Zeilenelementen lässt sich ein hoher Dynamikbereich realisieren. Der Dynamikbereich ist durch das Verhältnis unterschiedlicher Kontraste von Objekten 5 definiert, welches mit dem Sensor 1 noch auflösbar ist.

Bei Verwendung von CCD-Zeilenelementen als Empfänger 4 können Objekte 5 erfasst werden, bei deren Detektion maximale und minimale Empfangssignalamplituden Eₘᵢₙ und Eₘₐₓ registriert werden, deren Verhältnis bis Eₘₐₓ/Eₘᵢₙ = 10³ beträgt. Diese Dynamik kann auf Werte bis zu 10⁶ gesteigert werden, in dem die Integrationszeit, das heißt die Messzeit des Sensors 1 entsprechend gesteigert wird. Durch eine entsprechende Steigerung der Sendeleistung des Senders 3 lässt sich die Dynamik des Sensors 1 auf Werte bis zu 10⁷ steigern.

Ein weiterer Vorteil des CCD-Zeilenelements besteht darin, dass dieses über den gesamten Amplitudenbereich ein im Wesentlichen lineares Messsignal liefert.

Durch Verwendung eines CMOS-Zeilenelements als Empfänger 4 lässt sich ein Dynamikbereich von 10⁷ ohne Anpassung der Integrationszeit realisieren. Nachteilig bei der Verwendung eines CMOS-Zeilenelements ist, dass dieses im Gegensatz zu einem CCD-Zeilenelement keine lineare sondern eine logarithmische Kennlinie aufweist.

Durch die hohe Dynamik der Zeilenelemente und die regelbare Sendeleistung des Senders 3 wird eine im Vergleich zu bekannten Sensoren 1 wie zum Beispiel Kamerasystemen besonders hohe Nachweisempfindlichkeit erhalten. Dem Empfänger 4 ist eine Blende 15 vorgeordnet, deren Abmessungen an die Abmessungen des Zeilenelements angepasst sind. Die Blende 15 besteht aus einem Spalt in der Gehäusewand des zweiten Gehäuseelements 8 und ist mit einem Eintrittsfenster 16 verschlossen.

Das Eintrittsfenster 16 und das Austrittsfenster 13 begrenzen den Überwachungsbereich. Dabei sind das Austrittsfenster 13 und das Eintrittsfenster 16 gegenüberliegend angeordnet, wobei das Eintrittsfenster 16 in einer parallel zur Ebene des Eintrittsfensters 16 verlaufenden Ebene liegt.

Zwischen der Blende 15 und dem Empfänger 4 liegt ein optisches Filter 17, dessen Fläche an die Flächen des Empfängers 4 und der Blende 15 angepasst ist. Das Filter 17 ist als Tageslichtfilter, Richtungsfilter oder Interferenzfilter ausgebildet.

Mittels der Sendeoptik werden die Sendelichtstrahlen 2 auf die Oberfläche des Empfängers 4 fokussiert, so dass die Sendelichtstrahlen 2 die Empfangselemente 14 des Empfängers 4 bei freiem Strahlengang vollständig und homogen ausleuchten.

Die Längen des Austrittsfensters 13 und des Eintrittsfensters 16 entsprechen dabei der Länge des Empfängers 4. Der Strahldurchmesser der Sendelichtstrahlen 2 in Längsrichtung ist konstant. Dagegen nimmt der Strahldurchmesser der Sendelichtstrahlen 2 quer zur Längsrichtung des Empfängers 4 bei Durchlaufen des Überwachungsbereichs vom Austrittsfenster 13 bis zum Eintrittsfenster 16 durch die Fokussierungswirkung der Sendeoptik kontinuierlich ab. Dies ist insbesondere aus Figur 2 ersichtlich. Die Breiten des Austrittsfensters 13 und der Blende 15 mit dem Eintrittsfenster 16 sind dabei an die jeweilige lokale Strahlbreite der Sendelichtstrahlen 2 angepasst.
Mittels des erfindungsgemäßen Sensors 1 sind insbesondere die Konturen und Kanten von Objekten 5 erfassbar. Hierzu werden in der Auswerteeinheit 9 die durch Objekteingriffe entstehenden Abschattungen der Sendelichtstrahlen 2 durch eine entsprechende ortsaufgelöste Auswertung der Empfangssignale der einzelnen Empfangselemente 14 registriert. Die Auswerteeinheit 9 bildet somit die Mittel zur Erfassung von Konturen und/oder Kanten von Objekten 5.

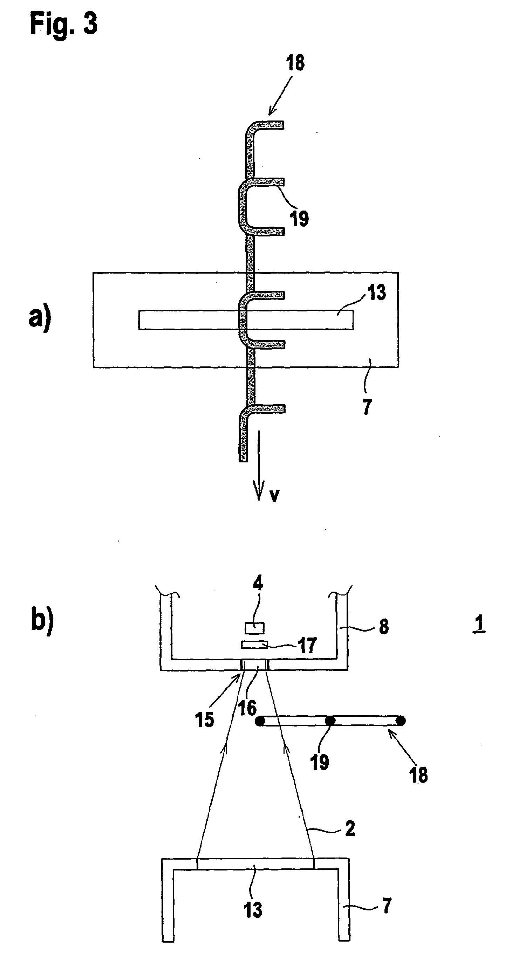

Ein erstes Ausführungsbeispiel zur Kontur- und Kantenerkennung ist in den Figuren 3a und 3b dargestellt. In diesem Fall wird der optische Sensor 1 zur Erfassung des Kantenverlaufs einer Textilbahn 18 eingesetzt. Die Textilbahn 18 wird dabei derart relativ zum Sensor 1 bewegt, dass die Kante der Textilbahn 18 quer zur Längsrichtung des Empfängers 4 verlaufend durch den Überwachungsbereich geführt ist.

Die Textilbahn 18 weist im vorliegenden Fall eine Netzstruktur auf, das heißt die Textilbahn 18 besteht aus einer vernetzten Struktur von Garnbündeln 19. Entsprechend dieser Netzstruktur verläuft die Kante der Textilbahn 18 nicht längs einer Geraden, sondern längs einer durchbrochenen Linie. Die so ausgebildete Kante der Textilbahn 18 wird mittels des Sensors 1 erfasst. Dabei ist die Textilbahn 18 in einer vorgegebenen Ebenen parallel zur Ebene des Empfängers 4 im Überwachungsbereich geführt, in welcher die Strahlbreite der Sendelichtstrahlen 2 gerade so groß ist, dass die Kantenstruktur der Textilbahn 18 vollständig ausgeleuchtet wird.

Dies hat zum einen den Vorteil, dass die längs des Außenrandes der Textilbahn 18 verlaufenden Garnbündel 19 eine große Abschattung der Sendelichtstrahlen 2 bewirken und somit zu einem hohen und Signalhub am Ausgang der abgeschatteten Empfangselemente 14 führen. Weiterhin ist vorteilhaft, dass mit den Sendelichtstrahlen 2 die gesamte Breite des Garnbündels 19 am Außenrand der Textilbahn 18 ausgeleuchtet wird. Durch die vollständige Ausleuchtung des Garnbündels 19 erfolgt eine optische Integration, das heißt Inhomogenitäten innerhalb des Garnbündels 19, deren Größen erheblich kleiner als die Strahlbreite der Sendelichtstrahlen 2 sind, gehen nicht in das Messsignal am Ausgang des Empfängers 4 ein.

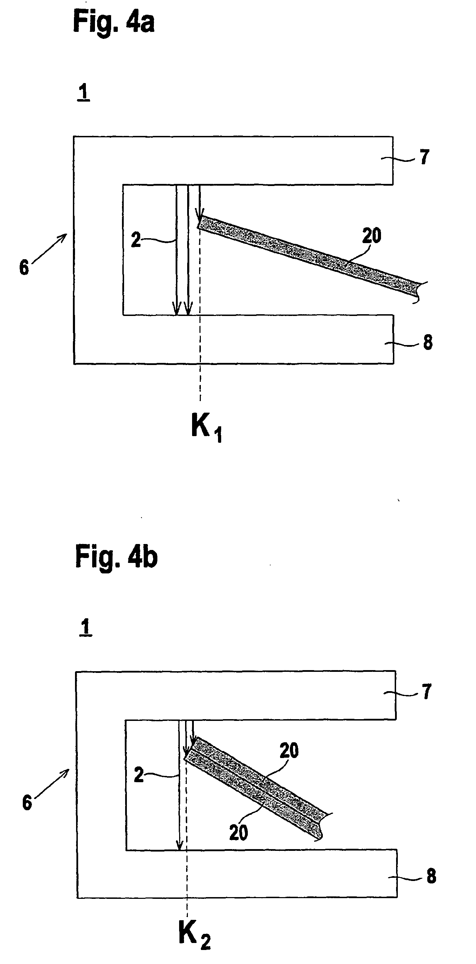

In den Figuren 4a und 4b ist ein weiteres Einsatzgebiet des erfindungsgemäßen Sensors 1 dargestellt. In diesem Fall wird mittels des Sensors 1 eine Unterscheidung von Blechen 20, die in Form von Einfach- und Doppelblechen beispielsweise einer blechverarbeitenden Maschine zugeführt werden, durchgeführt. Bei der Detektion derartiger Anordnungen lichtundurchlässiger flächiger Objekte 5 ist eine optische Messung im Durchlicht- oder Auflichtverfahren nicht möglich.

Demzufolge werden wie in den Figuren 4a und 4b dargestellt die zu detektierenden Einfach- oder Doppelbleche jeweils in vorgegebenen Sollpositionen relativ zum Sensor 1 so angeordnet, dass deren schmalseitigen Seitenflächen in den Überwachungsbereich ragen. Dabei sind die Ebenen der Einfach- und Doppelbleche in einem Winkel kleiner als 90° zur Strahlachse der Sendelichtstrahlen 2 orientiert. Durch diese Anordnung ist gewährleistet, dass die Sendelichtstrahlen 2 auf die schmalseitigen Seitenflächen der Bleche 20 treffen.

Befindet sich nur ein Blech 20 im Überwachungsbereich, so wird mit dem Sensor 1 die in Figur 4a mit K₁ bezeichnete Kantenlage des Einfachblechs detektiert.

Befinden sich zwei Bleche 20 im Überwachungsbereich, so wird mit dem Sensor 1 aufgrund der vergrößerten Abschattung der Sendelichtstrahlen 2 die in Figur 4b mit K₂ bezeichnete Kantenlage des Doppelbleches detektiert.

Die unterschiedlichen Kantenlagen K₁ und K₂ können vom Sensor 1 sicher aufgelöst werden. Durch die mit dem Sensor 1 erfassten unterschiedlichen Kantenlagen K₁ und K₂ wird eine sichere Unterscheidung von Einfach- und Doppelblechen ermöglicht.

Zur Verminderung von Fremdlichteinflüssen wird der Sender 3 des Sensors 1 bei den Anwendungsfällen gemäß den Figuren 3 und 4 vorzugsweise in einem vorgegebenen Sendetakt über die Auswerteeinheit 9 jeweils nur kurzzeitig aktiviert.

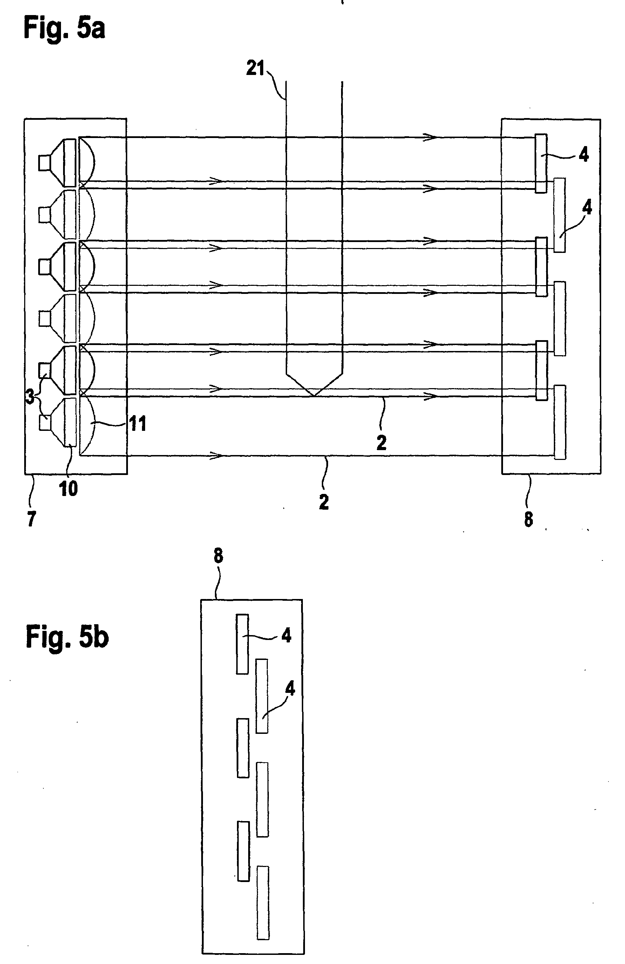

Die Figuren 5a und 5b zeigen ein zweites Ausführungsbeispiel des optischen Sensors 1 und einen weiteren Einsatzbereich für diesen Sensor 1.

Im vorliegenden Fall wird mittels des Sensors 1 eine Bohrerbruchkontrolle an einer Werkzeugmaschine ausgeführt. Dabei wird der Bohrer 21 der Werkzeugmaschine mittels des Sensors 1 über die gesamte Bohrerlänge lückenlos erfasst.

Hierzu besteht der Sensor 1 aus einer Mehrfachanordnung von Sendern 3 und einer Mehrfachanordnung von Empfängern 4. Dabei ist jedem Sender 3 ein Empfänger 4 zugeordnet, wobei die jeweiligen Sender-Empfängerpaare 3, 4 beidseits des Bohrers 21 gegenüberliegend angeordnet sind.

Die Sender 3 befinden sich in einem ersten Gehäuseelement 7. Die Empfänger 4 sind in einem zweiten Gehäuseelement 8 angeordnet. Im vorliegenden Fall bilden die Gehäuseelemente 7, 8 separate Einheiten. Da beidseits des Bohrers 21 nur ein geringer Einbauraum zur Verfügung steht, weisen die Gehäuseelemente 7, 8 eine entsprechend geringe Bautiefe auf. Die geringe Bautiefe wird durch die spezielle Mehrfachanordnung der Sender 3 und der Empfänger 4 erzielt. Die Gehäuseelemente 7, 8 erstrecken sich jeweils über die gesamte Länge des Bohrers 21. Die in den Figuren 5a und 5b nicht dargestellte Auswerteeinheit 9 kann in einem der Gehäuseelemente 7, 8 oder außerhalb dieser Einheiten angeordnet sein.
Jedem Sender 3 des Sensors 1 ist entsprechend dem Ausführungsbeispiel gemäß den Figuren 1 und 2 eine Sendeoptik in Form einer asphärischen Linse 10 und einer Zylinderlinse 11 nachgeordnet. Die Sendelichtstrahlen 2 sind über ein nicht dargestelltes Austrittsfenster 13 in der Gehäusewand des ersten Gehäuseelements 7 geführt. Prinzipiell kann auch jedem Sender 3 ein separates Austrittsfenster 13 zugeordnet sein.

Den Empfängern 4 ist entsprechend dem Ausführungsbeispiel gemäß den Figuren 1 und 2 jeweils eine Blende 15 in Form eines Spalts in der Gehäusewand des zweiten Gehäuseelements 8 vorgeordnet. Jeder Spalt ist mit einem Eintrittsfenster 16 verschlossen. Zwischen jeder Blende 15 und dem jeweils zugeordneten Empfänger 4 befindet sich ein ebenfalls nicht dargestelltes optisches Filter 17.

Die Sendelichtstrahlen 2 der Sender 3 werden analog zu dem Ausführungsbeispiel gemäß den Figuren 1 und 2 auf den jeweils zugeordneten Empfänger 4 fokussiert.

Um eine lückenlose Erfassung des Bohrers 21 zu erhalten, sind die Empfänger 4 und dementsprechend auch die Sender 3 in Längsrichtung des Bohrers 21 hintereinander angeordnet.

Dabei sind die Längsachsen der Empfänger 4 parallel zu einer in Richtung der Längsachse des Bohrers 21 verlaufenden Empfängerachse orientiert.

Wie insbesondere aus Figur 5b ersichtlich liegen die Empfänger 4 alternierend seitlich versetzt zu dieser Empfängerachse, so dass jeweils die Längsachsen der geradzahligen Empfänger 4 längs einer ersten parallel zur Empfängerachse verlaufenden Geraden und die Längsachsen ungeradzahliger Empfänger 4 längs einer zweiten parallel zur Empfängerachse verlaufenden Geraden angeordnet sind.
Dabei liegen die einander zugewandten längsseitigen Enden zweier aufeinander folgenden Empfänger 4 dicht nebeneinander. Durch diese Teilüberlappung benachbarter Empfänger 4 wird eine lückenlose Erfassung des gesamten Bohrers 21 erhalten.

Vorteilhafterweise werden die den geradzahligen Empfängern 4 zugeordneten Sendern 3 einerseits und die den ungeradzahligen Empfängern 4 zugeordneten Sendern 3 andererseits über die Auswerteeinheit 9 alternierend aktiviert. Bei einer Transversalbewegung des Bohrers 21 quer zum Überwachungsbereich erfolgt in der Auswerteeinheit 9 eine Synchronisation der Senderaktivieurng derart, dass entsprechend der Bewegung des Bohrers 21 jeweils die Sender 3 aktiviert werden, deren Sendelichtstrahlen 2 gerade auf den Bohrer 21 gerichtet sind. Durch die Anzahl der vom Bohrer 21 abgeschalteten Empfangselemente 14 wird in der Auswerteeinheit 9 die aktuelle Länge des Bohrers 21 ermittelt.

### Bezugszeichenliste

- (1): Optischer Sensor
- (2): Sendelichtstrahlen
- (3): Sender
- (4): Empfänger
- (5): Objekte
- (6): Gehäuse
- (7): Gehäuseelemente
- (8): Gehäuseelemente
- (9): Auswerteeinheit
- (10): Asphärische Linse
- (11): Zylinderlinse
- (12): Umlenkspiegel
- (13): Austrittsfenster
- (14): Empfangselemente
- (15): Blende
- (16): Eintrittsfenster
- (17): Optisches Filter
- (18): Textilbahn
- (19): Garnbündel
- (20): Bleche
- (21): Bohrer

- Eₘᵢₙ: Empfangssignalamplituden
- Eₘₐₓ: Empfangssignalamplituden
- K₁: Kantenlage
- K₂: Kantenlage

## Patentansprüche

1. Optischer Sensor mit wenigstens einem Sender und wenigstens einem in Abstand zu diesem angeordneten Empfänger, wobei die vom Sender emittierten Sendelichtstrahlen bei freiem Strahlengang auf den Empfänger geführt sind und bei einem Objekteingriff zumindest teilweise abgeschwächt sind, **dadurch gekennzeichnet, dass** der Empfänger (4) von einem eine vorgegebene Anzahl von Empfangselementen (14) aufweisenden Zeilenelement gebildet ist, wobei die Sendelichtstrahlen (2) auf die Empfangselemente (14) so fokussiert sind, dass die Strahlbreite der Sendelichtstrahlen (2) quer zur Längsachse des Zeilenelements vom Sender (3) zum Empfänger (4) hin kontinuierlich abnimmt, wobei die Strahlbreite der Sendelichtstrahlen (2) an der Oberfläche des Empfängers (4) der Breite des Zeilenelements entspricht, dass die Sendelichtstrahlen (2) bei freiem Strahlengang die Empfangselemente (14) vollständig ausleuchten, und dass Mittel zur Erfassung von Konturen und/oder Kanten von im Strahlengang der Sendelichtstrahlen (2) angeordneten Objekten (5) vorgesehen sind.

2. Optischer Sensor nach Anspruch 1, **dadurch gekennzeichnet, dass** das Zeilenelement als PIN-Dioden-Zeilenelement, CCD-Zeilenelement oder als CMOS-Zeilenelement ausgebildet ist.

3. Optischer Sensor nach einem der Ansprüche 1 oder 2, **dadurch gekennzeichnet, dass** der Sender (3) in einem ersten Gehäuseelement (7) angeordnet ist, und dass der Empfänger (4) in einem zweiten Gehäuseelement (8) angeordnet ist.

4. Optischer Sensor nach Anspruch 3, **dadurch gekennzeichnet, dass** dieser als Gabellichtschranke ausgebildet ist, wobei die Gehäuseelemente (7, 8) Bestandteil eines gabelförmigen Gehäuses (6) sind.

5. Optischer Sensor nach einem der Ansprüche 1 - 4, **dadurch gekennzeichnet, dass** dem Sender (3) zur Strahlformung der Sendelichtstrahlen (2) eine Sendeoptik nachgeordnet ist.

6. Optischer Sensor nach Anspruch 5, **dadurch gekennzeichnet, dass** die Sendeoptik aus einer Optik zur Kollimierung der Sendelichtstrahlen (2), insbesondere einer asphärischen Linse (10) und aus einer dieser nachgeordneten Zylinderlinse (11) zur Fokussierung der Sendelichtstrahlen (2) besteht.

7. Optischer Sensor nach einem der Ansprüche 5 oder 6, **dadurch gekennzeichnet, dass** die fokussierten Sendelichtstrahlen (2) durch ein Austrittsfenster (13) in der Gehäusewand des ersten Gehäuseelements (7) geführt sind.

8. Optischer Sensor nach einem der Ansprüche 1 - 7, **dadurch gekennzeichnet, dass** dem Empfänger (4) eine Blende (15) vorgeordnet ist, deren Länge an die Länge des Zeilenelements angepasst ist und dessen Breite an die Strahlbreite der Sendelichtstrahlen (2) angepasst ist.

9. Optischer Sensor nach Anspruch 8, **dadurch gekennzeichnet, dass** die Blende (15) von einem Spalt in der Gehäusewand des zweiten Gehäuseelements (8) gebildet ist.

10. Optischer Sensor nach Anspruch 9, **dadurch gekennzeichnet, dass** der Spalt in der Gehäusewand mittels eines Eintrittsfensters (16) verschlossen ist.

11. Optischer Sensor nach Anspruch 10, **dadurch gekennzeichnet, dass** das Eintrittsfenster (16) in einer parallel zur Ebene des Austrittsfensters (13) liegenden Ebene orientiert ist, wobei das Eintrittsfenster (16) dem Austrittsfenster (13) in Abstand gegenüberliegt.

12. Optischer Sensor nach einem der Ansprüche 8 - 11, **dadurch gekennzeichnet, dass** zwischen der Blende (15) und dem Empfänger (4) wenigstens ein optisches Filter (17) angeordnet ist.

13. Optischer Sensor nach Anspruch 12, **dadurch gekennzeichnet, dass** das optische Filter (17) von einem Richtungsfilter, einem Tageslichtfilter oder einem Interferenzfilter gebildet ist.

14. Optischer Sensor nach einem der Ansprüche 1 - 13, **dadurch gekennzeichnet, dass** die Mittel zur Erfassung von Konturen und /oder Kanten von Objekten (5) wenigstens eine Auswerteeinheit (9) zur Auswertung der am Ausgang des Empfängers (4) anstehenden Empfangssignale aufweisen.

15. Optischer Sensor nach Anspruch 14, **dadurch gekennzeichnet, dass** der Sender (3) von der Auswerteeinheit (9) angesteuert wird.

16. Optischer Sensor nach einem der Ansprüche 14 oder 15, **dadurch gekennzeichnet, dass** dieser eine Mehrfachanordnung von Empfängern (4) aufweist, deren Empfangssignale in der Auswerteeinheit (9) ausgewertet werden.

17. Optischer Sensor nach Anspruch 16, **dadurch gekennzeichnet, dass** jedem Empfänger (4) ein separater Sender (3) zugeordnet ist, wobei die Sender (3) von der Auswerteeinheit (9) angesteuert sind.

18. Optischer Sensor nach einem der Ansprüche 16 oder 17, **dadurch gekennzeichnet, dass** die Empfänger (4) mit parallel zu einer Empfängerachse verlaufenden Längsachsen in Richtung der Empfängerachse hintereinander angeordnet sind.

19. Optischer Sensor nach Anspruch 18, **dadurch gekennzeichnet, dass** die Empfänger (4) alternierend seitlich versetzt zueinander angeordnet sind, so dass die Längsachsen geradzahliger Empfänger (4) längs einer ersten parallel zur Empfängerachse verlaufenden Geraden und die Längsachsen ungeradzahliger Empfänger (4) längs einer zweiten parallel zur Empfängerachse verlaufenden Geraden hintereinander angeordnet sind.

20. Optischer Sensor nach Anspruch 19, **dadurch gekennzeichnet, dass** jeweils die einander zugewandten längsseitigen Enden zweier aufeinander folgender Empfänger (4) dicht nebeneinander liegen.

21. Verwendung eines optischen Sensors nach einem der Ansprüche 16 - 20 zur Bohrerkontrolle an Werkzeugmaschinen, wobei von den Sendelichtstrahlen (2) der Sender (3) die gesamte Länge des Bohrers (21) erfasst ist.

22. Verwendung eines optischen Sensors nach Anspruch 21, **dadurch gekennzeichnet, dass** zur Erfassung des Bohrers (21) in einem vorgegebenen Sendetakt jeweils nacheinander die den ungeradzahligen Empfängern (4) zugeordneten Sender (3) und die den geradzahligen Empfängern (4) zugeordneten Sender (3) aktiviert werden.

23. Verwendung eines optischen Sensors nach einem der Ansprüche 1 - 20 zur Ermittlung der Anzahl von übereinander liegend angeordneten flächigen Objekten (5), wobei die Objektebenen in einem Winkel kleiner als 90° zu den Strahlachsen der Sendelichtstrahlen (2) verlaufen, so dass diese auf die schmalseitigen Seitenflächen der in Sollpositionen liegenden Objekte (5) treffen.

24. Verwendung eines optischen Sensors nach Anspruch 23, **dadurch gekennzeichnet, dass** die Objekte (5) von aufeinander liegenden Blechen (20) gebildet sind.

25. Verwendung eines optischen Sensors nach einem der Ansprüche 1 - 20 zur Erfassung von Randkonturen bahnfönniger Objekte (5), wobei die Randkonturen durch den Strahlengang der Sendelichtstrahlen (2) hindurch bewegt werden.

26. Verwendung eines optischen Sensors nach Anspruch 25, **dadurch gekennzeichnet, dass** die bahnförmigen Objekte (5) von netzartigen Textilbahnen (18) gebildet sind.

## Claims

1. Optical sensor with at least one transmitter and at least one receiver arranged at a spacing therefrom, wherein the transmitted light beams emitted by the transmitter are led to the receiver in the case of a free beam path and are at least partly attenuated in a case of intervention of an object, **characterised in that** the receiver (4) is formed by a line element having a predetermined number of receiving elements (14), wherein the transmitted light beams (2) are so focussed on the receiving elements (14) that the beam width of the transmitted light beams (2) transversely to the longitudinal axis of the line element continuously decreases from the transmitter (3) to the receiver (4), wherein the beam width of the transmitted light beams (2) at the surface of the receiver (4) corresponds with the width of the line element, that the transmitted light beams (2) fully illuminate the receiving elements (14) when the beam path is free, and that means for detection of contours and/or edges of objects (5) arranged in the beam path of the transmitted light beams (2) are provided.

2. Optical sensor according to claim 1, **characterised in that** the line element is constructed as a PIN diode line element, a CCD line element or a CMOS line element.

3. Optical sensor according to one of claims 1 and 2, **characterised in that** the transmitter (3) is arranged in a first housing element (7) and that the receiver (4) is arranged in second housing element (8).

4. Optical sensor according to claim 3, **characterised in** this is constructed as a forked light barrier, wherein the housing elements (7, 8) are a component of a forked housing (6).

5. Optical sensor according to any one of claims 1 to 4, **characterised in that** a transmission optical system for beam formation of the transmitted light beams (2) is arranged downstream of the transmitter (3).

6. Optical sensor according to claim 5, **characterised in that** the transmission optical system consists of an optical system for collimation of the transmitted light beams (2), particularly and aspherical lens (10), and of a cylinder lens (11), which is arranged downstream thereof, for focusing the transmitted light beams (2).

7. Optical sensor according to one of claims 5 and 6, **characterised in that** the focused transmitted light beams (2) are led through an exit window (13) in the housing wall of the first housing element (7).

8. Optical sensor according to any one of claims 1 to 7, **characterised in that** an aperture (15), the length of which is matched to the length of the line element and the width of which is matched to the beam width of the transmitted light beams (2), is arranged upstream of the receiver (4).

9. Optical sensor according to claim 8, **characterised in that** the aperture (15) is formed by a gap in the housing wall of the second housing element (8).

10. Optical sensor according to claim 9, **characterised in that** the gap in the housing wall is closed by means of an entry window (16).

11. Optical sensor according to claim 10, **characterised in that** the entry window (16) is oriented in a plane lying parallel to the plane of the exit window (13), wherein the entry window (16) is opposite the exit window (13) at a spacing.

12. Optical sensor according to any one of claims 8 to 11, **characterised in that** at least one optical filter (17) is arranged between the aperture (15) and the receiver (4).

13. Optical sensor according to claim 12, **characterised in that** the optical filter (17) is formed by a directional filter, a daylight filter or an interference filter.

14. Optical sensor according to any one of claims 1 to 13, **characterised in that** the means for detection of contours and/or edges of objects (5) comprises at least one evaluating unit (9) for evaluation of the received signals present at the output of the receiver (4).

15. Optical sensor according to claim 14, **characterised in that** the transmitter (3) is activated by the evaluating unit (9).

16. Optical sensor according to one of claims 14 and 15, **characterised in that** this comprises a multiple arrangement of receivers (4), the received signals of which are evaluated in the evaluating unit (9).

17. Optical sensor according to claim 16, **characterised in that** a separate transmitter (3) is associated with each receiver (4), wherein the transmitters (3) are activated by the evaluating unit (9).

18. Optical sensor according to one of claims 16 and 17, **characterised in that** the receivers (4) are arranged one behind the other with longitudinal axes, which extend parallel to a receiver axis, in the direction of the receiver axis.

19. Optical sensor according to claim 18, **characterised in that** the receivers (4) are arranged to be laterally offset relative to one another in alternation so that the longitudinal axes of even-numbered receivers (4) are arranged one behind the other along a first straight line extending parallel to the receiver axis and the longitudinal axes of uneven-numbered receivers (4) are arranged one behind another along a second straight line extending parallel to the receiver axis.

20. Optical sensor according to claim 19, **characterised in that** the mutually facing longitudinal-side ends in each instance of two successive receivers (4) lie tightly adjacent to one another.

21. Use of an optical sensor according to any one of claims 16 to 20 for drill control at machine tools, wherein the entire length of the drill (21) is detected by the transmitted light beams (2) of the transmitter (3).

22. Use of an optical sensor according to claim 21, **characterised in that** for detection of the drill (21) the transmitters (3) associated with the uneven-numbered receivers (4) and the transmitters (3) associated with the even-numbered receivers (4) are respectively activated in succession in a predetermined transmitting cycle.

23. Use of an optical sensor according to any one of claims 1 to 20 for detection of the number of areal objects (5) arranged to lie one above the other, wherein the object planes extend in an angle smaller than 90° relative to the beam axes of the transmitted light beams (2) so that these impinge on the narrow-side side surfaces of the objects (5) lying in target positions.

24. Use of an optical sensor according to claim 23, **characterised in that** the objects (5) are formed by plates (20) lying one on the other.

25. Use of an optical sensor according to any one of claims 1 to 20 for detection of edge contours of web-shaped objects (5), wherein the edge contours are moved through the beam path of the transmitted light beams (2).

26. Use of an optical sensor according to claim 25, **characterised in that** the web-shaped objects (5) are formed by netlike textile webs (18).

## Revendications

1. Capteur optique comportant au moins un émetteur et au moins un récepteur disposé à distance de celui-ci, les rayons lumineux d'émission émis par l'émetteur étant guidés sur le récepteur lorsque le chemin optique est libre et au moins partiellement affaiblis en cas d'intrusion d'un objet, **caractérisé en ce que** le récepteur (4) est formé d'un élément linéaire présentant un nombre prédéfini d'éléments de réception (14), les rayons lumineux d'émission (2) étant focalisés sur les éléments de réception (14) de façon que la largeur de faisceau des rayons lumineux d'émission (2) diminue continuellement de l'émetteur (3) vers le récepteur (4) transversalement à l'axe longitudinal de l'élément linaire, la largeur de faisceau des rayons lumineux d'émission (2) à la surface du récepteur (4) correspondant à la largeur de l'élément linéaire, que les rayons lumineux d'émission (2) illuminent entièrement les éléments de réception (14) lorsque le chemin optique est libre, et que des moyens sont prévus pour saisir les contours et/ou arêtes des objets (5) disposés dans le chemin optique des rayons lumineux d'émission (2).

2. Capteur optique selon la revendication 1, **caractérisé en ce que** l'élément linéaire est réalisé sous la forme d'un élément linéaire à diodes PIN, d'un élément linéaire CCD ou d'un élément linéaire CMOS.

3. Capteur optique selon une des revendications 1 ou 2, **caractérisé en ce que** l'émetteur (3) est disposé dans un premier élément de boîtier (7), et que le récepteur (4) est disposé dans un deuxième élément de boîtier (8).

4. Capteur optique selon la revendication 3, **caractérisé en ce que** celui-ci est réalisé sous la forme d'une barrière lumineuse à fourche, les éléments de boîtier (7, 8) étant les constituants d'un boîtier en forme de fourche (6).

5. Capteur optique selon une des revendications 1 à 4, **caractérisé en ce qu'**une optique d'émission est placée après l'émetteur (3) pour la mise en forme du faisceau des rayons lumineux d'émission (2).

6. Capteur optique selon la revendication 5, **caractérisé en ce que** l'optique d'émission est composée d'une optique pour collimater les rayons lumineux d'émission (2), en particulier d'une lentille asphérique (10) et d'une lentille cylindrique (11) placée après celle-ci pour focaliser les rayons lumineux d'émission (2).

7. Capteur optique selon une des revendications 5 ou 6, **caractérisé en ce que** les rayons lumineux d'émission (2) focalisés sont guidés à travers une fenêtre de sortie (13) dans la paroi de boîtier du premier élément de boîtier (7).

8. Capteur optique selon une des revendications 1 à 7, **caractérisé en ce que** qu'un diaphragme (15) est placé avant le récepteur (4), dont la longueur est adaptée à la longueur de l'élément linéaire et dont la largeur est adaptée à la largeur de faisceau des rayons lumineux d'émission (2).

9. Capteur optique selon la revendication 8, **caractérisé en ce que** le diaphragme (15) est formé par une fente dans la paroi de boîtier du deuxième élément de boîtier (8).

10. Capteur optique selon la revendication 9, **caractérisé en ce que** la fente dans la paroi de boîtier est fermée au moyen d'une fenêtre d'entrée (16).

11. Capteur optique selon la revendication 10, **caractérisé en ce que** la fenêtre d'entrée (16) est orientée dans un plan situé parallèlement au plan de la fenêtre de sortie (13), la fenêtre d'entrée (16) étant située en face de la fenêtre de sortie (13), à distance de celle-ci.

12. Capteur optique selon une des revendications 8 à 11, **caractérisé en ce qu'**au moins un filtre optique (17) est disposé entre le diaphragme (15) et le récepteur (4).

13. Capteur optique selon la revendication 12, **caractérisé en ce que** le filtre optique (17) est formé par un filtre directionnel, un filtre de lumière du jour ou un filtre à interférence.

14. Capteur optique selon une des revendications 1 à 13, **caractérisé en ce que** les moyens pour saisir les contours et/ou arêtes d'objets (5) présentent au moins une unité d'évaluation (9) pour évaluer les signaux de réception apparaissant à la sortie du récepteur (4).

15. Capteur optique selon la revendication 14, **caractérisé en ce que** l'émetteur (3) est commandé par l'unité d'évaluation (9).

16. Capteur optique selon une des revendications 14 ou 15, **caractérisé en ce que** celui-ci présente un arrangement multiple de récepteurs (4) dont les signaux de réception sont évalués dans l'unité d'évaluation (9).

17. Capteur optique selon la revendication 16, **caractérisé en ce qu'**à chaque récepteur (4) est associé un émetteur (3) séparé, les émetteurs (3) étant commandés par l'unité d'évaluation (9).

18. Capteur optique selon une des revendications 16 ou 17, **caractérisé en ce que** les récepteurs (4) sont disposés l'un derrière l'autre dans la direction de l'axe de récepteur avec leurs axes longitudinaux s'étendant parallèlement à un axe de récepteur.

19. Capteur optique selon la revendication 18, **caractérisé en ce que** les récepteurs (4) sont alternativement décalés latéralement les uns par rapport aux autres, de sorte que les axes longitudinaux des récepteurs (4) pairs sont disposés l'un derrière l'autre le long d'une première droite s'étendant parallèlement à l'axe de récepteur et les axes longitudinaux des récepteurs (4) impairs le long d'une deuxième droite s'étendant parallèlement à l'axe de récepteur.

20. Capteur optique selon la revendication 19, **caractérisé en ce que** les extrémités longitudinales tournées l'une vers l'autre de deux récepteurs (4) successifs sont chaque fois disposées tout près l'une de l'autre.

21. Utilisation d'un capteur optique selon une des revendications 16 à 20 pour le contrôle de forets sur des machines-outils, toute la longueur du foret (21) étant saisie par les rayons lumineux d'émission (2) des émetteurs (3).

22. Utilisation d'un capteur optique selon la revendications 21, **caractérisée en ce que** pour saisir le foret (21), les émetteurs (3) associés aux récepteurs (4) impairs et les émetteurs (3) associés aux récepteurs (4) pairs sont chaque fois activés l'un après l'autre à une cadence d'émission prédéfinie.

23. Utilisation d'un capteur optique selon une des revendications 1 à 20 pour déterminer le nombre d'objets (5) plans disposés les uns au-dessus des autres, les plans des objets faisant un angle inférieur à 90° avec les axes de faisceau des rayons lumineux d'émission (2), de sorte que ceux-ci arrivent sur les surfaces latérales du petit côté des objets (5) situés dans des positions de consigne.

24. Utilisation d'un capteur optique selon la revendication 23, **caractérisée en ce que** les objets (5) sont formés de tôles (20) posées les unes sur les autres.

25. Utilisation d'un capteur optique selon une des revendications 1 à 20 pour saisir les contours de bordure d'objets (5) en forme de bande, les contours de bordure étant déplacés à travers le chemin optique des rayons lumineux d'émission (2).

26. Utilisation d'un capteur optique selon la revendication 25, **caractérisée en ce que** les objets (5) en forme de bande sont formés de bandes textiles réticulées (18).
